# EUROPEAN PATENT APPLICATION

(11) **EP 1 189 258 A2**
(43) Date of publication of application: **20.03.2002**
(21) Application number: 01121279.2
(22) Date of filing: 05.09.2001
(51) Int. Cl.: H01J 37/32

(54) **Vacuum arc evaporation apparatus**

(30) Priority: 18.09.2000 JP 2000282012
(71) Applicant: Nissin Electric Co., Ltd., Kyoto-shi, Kyoto 615 (JP)
(72) Inventor: Mikami, Takashi, Ukyo-ku, Kyoto-shi, Kyoto, 615 (JP); Murakami, Hiroshi, Ukyo-ku, Kyoto-shi, Kyoto, 615 (JP); Miyake, Koji, Ukyo-ku, Kyoto-shi, Kyoto, 615 (JP)
(74) Representative: Grünecker, Kinkeldey, Stockmair & Schwanhäusser Anwaltssozietät

(57) **Abstract**

In a vacuum arc evaporation apparatus 10c, a magnetic member 46, cylindrical or annular in shape, is disposed on or near the outer peripheral part of an anode 36, cylindrical or annular in shape. The anode 36 is located in front of a cathode 30 in a vacuum arc evaporation source 20, while surrounding the front part of the same. The anode 36 and the magnetic member 46 are at an equal potential. The magnetic member 46 is made of a ferromagnetic material. With such an arrangement, of the magnetic lines 58 of force generated by a magnetic filter 50, the number of those magnetic lines passing through the anode 36 or its vicinity is increased. As a result, electrons emitted from the cathode 30 by the arc discharge are easy to reach the anode 36, and the arc discharge can be maintained even in a strong magnetic field.

## Description

### BACKGROUND OF THE INVENTION

### 1. Field of the Invention

The present invention relates to a vacuum arc evaporation apparatus used for forming a thin film on a surface of a substrate, such as automobile part, machine part, tool, mold, lens, glass, or a semiconductor substrate. More specifically, the invention relates to a vacuum arc evaporation apparatus with a magnetic filter which generates a magnetic field, and curves and transports a stream of plasma generated by a vacuum arc evaporation source under the generated magnetic field, and outputs the plasma stream after removing coarse particles from the plasma, wherein the maintaining of arc discharge in the vacuum arc evaporation source is prevented from being difficult when an efficiency of transporting the plasma stream is increased by increasing an intensity of the magnetic field developed by the magnetic filter.

### 2. Description of the Related Art

There is a method for forming a thin film on a surface of a substrate by drawing ions (which mean positive ions in this specification) contained in a plasma generated by a vacuum arc evaporation source toward the substrate under negative bias voltage or the like. The vacuum arc evaporation source evaporates a cathode by vacuum arc discharge to thereby generate the plasma containing a cathode material. This method is called a vacuum arc evaporation method or an arc ion plating method. This method has advantageous features of high film-forming rate and high adhesion property.

The high film-forming rate is due to the fact that a large amount of cathode material is evaporated from the cathode by the utilization of the vacuum arc discharge. The high adhesion property is due to the fact that ions contained in the plasma draw toward the substrate and collided therewith under an electric field caused by the negative bias voltage.

The cathode material evaporated from the cathode of the vacuum arc evaporation source contains fine particles preferable for the film-forming, and coarse particles (also called droplets or macro-particles) whose diameter is several µm to several tens µm. Adhesion of such coarse particles to the substrate causes deterioration of the smoothness and adhesion property of a surface of the resultant film.

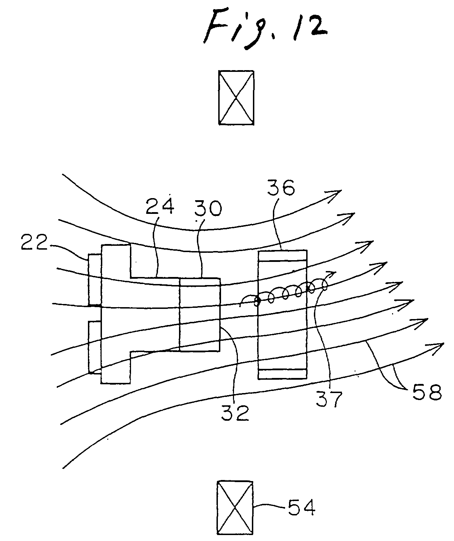

To cope with this, there is proposed a vacuum arc evaporation apparatus 10a as shown in Fig. 11. The vacuum arc evaporation apparatus 10a includes a vacuum arc evaporation source 20 as referred to above, and a magnetic filter 50. The magnetic filter 50 curves and transports a stream of plasma 38 generated by the vacuum arc evaporation source 20 under a magnetic field, and outputs the plasma stream after removing the coarse particles from the plasma.

In the apparatus, the vacuum arc evaporation source 20 includes a cathode 30 mounted on a cathode holder 24, and a cylindrical or annular anode 36 disposed in front of an evaporating face 32 of the cathode 30 (in an evaporating direction of the cathode material 34). The cathode 30 is caused to evaporate cathode materials by the vacuum arc discharge occurring between the cathode 30 and the anode 36, thereby generating plasma containing the cathode materials (making the cathode 30).

The cathode 30 contains amaterial (e.g., metal of titanium or the like, alloy of TiAl, carbon (graphite) or the like), which is selected in accordance with a kind of film to be formed. The anode 36 is usually made of copper. The cathode holder 24 is made of a non-magnetic metal.

In this apparatus, the anode 36 is electrically grounded. Arc discharge voltage of several tens V to 100V or therearound is applied from an arc power source 44 to between the anode 36 and the cathode 30, with the cathode 30 being at the negative polarity. Reference numeral 40 is a trigger electrode and 42 is an insulating material.

The cathode holder 24 is mounted on a support plate 28 through an insulating material 26. The support plate 28 covers one end of a transporting duct 52 forming the magnetic filter 50. A magnet (permanent magnet) 22 for confining an arc spot (cathode point of the arc discharge) within the evaporating face 32 of the cathode 30 by a magnetic field is provided on the rear side of the cathode holder 24.

In this apparatus, the magnetic filter 50 includes the curved transporting duct 52, a magnetic coil 54 , and a DC power source 56. The magnetic coil 54 generates a magnetic field curved along the transporting duct 52. The DC power source 56 excites the magnetic coil 54. The magnetic coil 54 may be a plurality of toroidal coils as illustrated, or a solenoid coil wound around the outer peripheral part of the transporting duct 52. Part of magnetic lines 58 of force generated by the magnetic coil 54 is roughly illustrated in Fig. 11. The magnetic lines 58 extend along the inner wall of the transporting duct 52 as shown. In a region including the cathode 30 and the anode 36, the magnetic lines 58 are distributed as illustrated in Fig. 12.

An angle α of the curve of the transporting duct 52 is preferably selected such that a substrate 64 in a film-forming chamber 60 cannot be seen directly from the cathode 30 in the vacuum arc evaporation source 20. A specific example of α is about 90°.

The members located close to the magnetic coil 54, e.g., the transporting duct 52, the support plate 28 and the film-forming chamber 60, are made of non-magnetic material so as not to disturb the magnetic lines 58 (magnetic field) developed by the magnetic coil 54.

The vacuum arc evaporation apparatus 10a including the vacuum arc evaporation source 20 and the magnetic filter 50 is coupled to the film-forming chamber 60 in a state that the other end of the transporting duct 52 (opposite to the vacuum arc evaporation source 20) is directed to the substrate 64, whereby a film-forming apparatus is formed. The film-forming chamber 60 includes a holder 62 holding the substrate 64 on which a film is to be formed. The film-forming apparatus is called a vacuum arc evaporation apparatus or an arc ion plating apparatus. The transporting duct 52, together with the film-forming chamber 60, is vacuumed by a vacuuming apparatus.

The plasma stream 38 generated by the vacuum arc evaporation source 20 is transported along the magnetic field within the magnetic filter 50, and output from the other end of the magnetic filter 50 and led to near the substrate 64 within the film-forming chamber 60. Of the coarse particles contained in the plasma stream 38, those particles not charged straightforwardly move while not being influenced by the magnetic field, and collide with the inner wall of the transporting duct 52. Accordingly, those coarse particles are not derived from the magnetic filter 50 and fail to reach the substrate 64. The radium (Raman radius) of a spiral motion of a coarse particle in the magnetic field extremely increases proportional to a mass of the coarse particle, even if it is the charged one. Accordingly, those particles hit the inner wall of the transporting duct 52 and fins (not shown) projected from the inner wall, anddisappear (adhere thereto) . As a result, the plasma stream 38 little containing the coarse particles are output from the magnetic filter 50, and led to near the substrate 64. Accordingly, there is no chance that the coarse particles adhere to the substrate 64.

At this time, when a potential at the substrate 64 is lower than that of the plasma stream 38, for example, by applying a negative bias voltage to the substrate 64, the ions contained in the plasma stream 38 are drawn to the substrate 64 by the potential difference, so that the ions hit the latter.

In the vacuum arc evaporation apparatus 10a, if an intensity of magnetic field (flux density) generated by the magnetic coil 54 of the magnetic filter 50 is increased, an efficiency of transporting the plasma stream 38 by the magnetic filter 50 is increased. Accordingly, the amount of plasma stream 38 output from the magnetic filter 50 is increased and hence a film-forming rate at which a film is formed on the substrate 64 is increased.

When the field strength is increased, a magnetic field also increases in the vicinity of the cathode 30 and the anode 36 in the vacuum arc evaporation source 20. Electrons 37 emitted from the cathode 30 by the arc discharge, as shown in Fig. 12, are firmly captured by magnetic lines 58 generated by the magnetic coil 54, so that those electrons pass through a space within the anode 36 and are hard to reach the anode 36. As the intensity of magnetic field by the magnetic coil 54 is increased, a larger number of the magnetic lines 58 generated by the magnetic coil 54 pass through the space within the anode 36. As a result, the electrons 37 do not hit the anode 36 and are easy to pass through the anode 36. When the electrons 37 emitted from the cathode 30 are hard to reach the anode 36, it is difficult to maintain the arc discharge between the cathode 30 and the anode 36. In other words, an initial discharge is hard to occur between the cathode 30 and the anode 36. Further, it is difficult to maintain the subsequent discharge.

Thus, in the prior art vacuum arc evaporation apparatus 10a, when attempt is made to increase an efficiency of transporting the plasma stream 38 by increasing an intensity of magnetic field by the magnetic filter 50, it is difficult to maintain the arc discharge in the vacuum arc evaporation source 20. Accordingly, it is difficult to secure both the transport efficiency of the plasma stream 38 and the maintaining of the arc discharge in the vacuum arc evaporation source 20.

Particularly, when the cathode 30 is made of carbon or a material mainly containing carbon, the maintaining of the arc discharge is more difficult when the field strength in the magnetic filter 50 is increased. The reason for this is that the arc discharge of the carbon or the material mainly containing carbon is originally difficult, and that the electrons 37 emitted from the cathode 30 hardly reach the anode 36 as described above and hence, the arc discharge more hardly occurs.

When the cathode 30 is made of carbon or the material mainly containing carbon, which is difficult in maintaining the arc discharge, or even when it is made of another material, the arc discharge may easily be maintained in a manner that gas, e.g., inert gas or reaction gas, is introduced into the transporting duct 52, thereby intentionally increasing a gas pressure in the vicinity of the cathode 30. However, this approach creates other problems anew. A large amount of gas ion caused by the arc discharge is contained in the plasma stream 38, and adversely affects the film-forming process. A large amount of gas ion enters the substrate 64, so that a film quality of a thin film formed on a surface of the substrate 64 is changed, an internal stress in the film increases, or the substrate 64 is heated unnecessarily.

### SUMMARY OF THE INVENTION

Accordingly, an object of the present invention is to provide a vacuum arc evaporation apparatus including a vacuum arc evaporation source and a magnetic filter in which arc discharge can be maintained within the vacuum arc evaporation source without the gas introduction even when an efficiency of transporting plasma stream is improved by increasing an intensity of magnetic field developed by the magnetic filter.

The above-mentioned object can be achieved by a first vacuum arc evaporation apparatus according to the present invention, comprising: a vacuum arc evaporation source including a cathode and an anode located in front of an evaporating face of the cathode, the vacuum arc evaporation source generating stream of plasma containing cathode materials by evaporating cathode materials from the cathode under a vacuum arc discharge between the cathode and the anode; a magnetic filter for curving and transporting the plasma stream generated by the vacuum arc evaporation source by a magnetic field to remove coarse particles from the plasma stream, and outputting the plasma stream in which coarse particles have been removed; and a magnetic member disposed in front of the evaporating face of the cathode and close to the anode in the vacuum arc evaporation source.

In the first vacuum arc evaporation apparatus, with provision of the magnetic member, a distribution of the magnetic lines of force (i.e., magnetic flux) developed by the magnetic filter in the region ranging from the cathode to the anode in the vacuum arc evaporation source is configured so as to be suitable for the maintaining of arc discharge between the cathode and the anode. Specifically, with the provision of the magnetic member near the anode, the magnetic lines developed by the magnetic filter are attracted in part to the magnetic member. This phenomenon occurs also when the field strength of the magnetic filter is increased. Accordingly, the magnetic lines passing through the anode or its vicinity from the cathode of the vacuum arc evaporation source are increased in number. As the result of the increase of the flux density, of electrons that are emitted from the cathode by the arc discharge, those electrons that are captured by the magnetic lines of force passing through the anode and its vicinity and reach the anode, are increased in number. With this, the initial arc discharge and the maintaining of the subsequent arc discharge are easy in the vacuum arc evaporation source, whereby the arc discharge is stabilized.

Also, in a case where an efficiency of transporting a stream of plasma is improved by increasing an intensity of magnetic field developed by the magnetic filter, the arc discharge can be stabilized and maintained in the vacuum arc evaporation source without gas introduction. Accordingly, the transport efficiency improvement of the plasma stream in the magnetic filter and the arc discharge maintaining in the vacuum arc evaporation source can both be secured without the gas introduction.

Thus, the film-forming apparatus having the thus constructed vacuum arc evaporation apparatus can form a film on a substrate at high rate in a manner that the plasma stream is transported at high transport efficiency, while removing coarse particles, and further can eliminate the adverse effect on the formed film by the gas introduction. Those advantageous effects may be achieved by very simple construction, viz., provision of the magnetic member. This fact also suppresses the apparatus size increase.

In the first vacuum arc evaporation apparatus, it is preferable that the anode is located between the magnetic member and the evaporating face of the cathode.

In the first vacuum arc evaporation apparatus, the magnetic member is not interposed between the evaporating face of the cathode and the anode. Accordingly, electrons that are emitted from the cathode and captured by the magnetic lines of force are easy to reach the anode. This is very convenient for the maintaining of the arc discharge.

Further, in the first vacuum arc evaporation apparatus, it is also preferable that the anode of the vacuum arc evaporation source is configured such that when positioned in place, the anode surrounds the front part of the cathode, and the magnetic member is disposed on or near an outer peripheral part of the anode in a state that the magnetic member is located in front of the cathode while surrounding the front part of the cathode.

Where the anode is not provided with the magnetic member, most of the magnetic lines generated by the magnetic filter pass through the space within the anode. With this, electrons emitted from the cathode are easy to pass through the anode while not colliding with the anode. In the vacuum arc evaporation apparatus according to the present invention, the magnetic member is disposed so as to surround the front part of the cathode. Where the magnetic member is used as described above, the magnetic lines may be attracted to the anode or its vicinity. The effects comparable with those of the first vacuum arc evaporation apparatus are more remarkably manifested.

In the vacuum arc evaporation apparatus, the anode of the vacuum arc evaporation source may include a plurality of bar-like members, which are disposed along the evaporating face of the cathode while being located outside the evaporating face of the cathode.

Electrons emitted from the cathode are easy to pass between the anode while not colliding with the anode, if the magnetic member is not used, when an intensity of magnetic field generated by the magnetic filter is increased as in the case where the anode surrounds the front part of the cathode when it is positioned in place. In the vacuum arc evaporation apparatus according to the present invention, with provision of the magnetic member, the magnetic field generated by the magnetic filter is attracted to the anode or its vicinity. Accordingly, the number of magnetic lines of force going to the anode is increased, thereby enabling the arc discharge to be maintained in a strong magnetic field. Therefore, the effects of this vacuum arc evaporation apparatus are comparable with those of the first vacuum arc evaporation apparatus.

The above-mentioned object can be also achieved by a second vacuum arc evaporation apparatus according to the present invention, comprising: a vacuum arc evaporation source including a cathode and an anode located in front of an evaporating face of the cathode, the vacuum arc evaporation source generating stream of plasma containing cathode materials by evaporating cathode materials from the cathode under a vacuum arc discharge between the cathode and the anode; and a magnetic filter for curving and transporting the plasma stream generated by the vacuum arc evaporation source by a magnetic field to remove coarse particles from the plasma stream, and outputting the plasma stream in which coarse particles have been removed, wherein the anode of the vacuum arc evaporation source is made of a magnetic material.

In the second vacuum arc evaporation apparatus, it is preferable that the anode of the vacuum arc evaporation source is configured such that when positioned in place, the anode surrounds the front part of the cathode.

Further, in the second vacuum arc evaporation, it is also preferable that the anode of the vacuum arc evaporation source includes a plurality of bar-like members, which are disposed along the evaporating face of the cathode while being located outside the evaporating face of the cathode.

In the second vacuum arc evaporation apparatus, the anode per se attracts magnetic lines of force generated by the magnetic filter. Accordingly, the number of magnetic lines going to the anode is increased, enabling the arc discharge to be maintained in a strong magnetic field. The advantageous effects produced by this apparatus are comparable with those of the first vacuum arc evaporation apparatus. Further, reduction of the number of required parts and construction simplification are secured.

Further, the above-mentioned object ca be achieved by a third vacuum arc evaporation apparatus according to the present invention, comprising: a vacuum arc evaporation source including a cathode and an anode located in front of an evaporating face of the cathode, the vacuum arc evaporation source generating stream of plasma containing cathode materials by evaporating cathode materials from the cathode under a vacuum arc discharge between the cathode and the anode; and a magnetic filter for curving and transporting the plasma stream generated by the vacuum arc evaporation source by a magnetic field to remove coarse particles from the plasma stream, and outputting the plasma stream in which coarse particles have been removed, wherein the anode of the vacuum arc evaporation source includes at least one bar-like anode which is disposed in front of the evaporating face of the cathode while being extended along the evaporating face.

In the third vacuum arc evaporation apparatus, even in a case where an intensity of magnetic field developed by the magnetic filter is increased and magnetic lines of force developed by the magnetic coil passes through the evaporating face in the direction perpendicular to the evaporating face, the electrons captured by the magnetic lines are easy to reach the anode and hence the arc discharge can be maintained since the anode is located crossing the magnetic lines. Accordingly, even in such a case of increasing the transport efficiency of the plasma stream by increasing the intensity of magnetic field generated by the magnetic filter, the arc discharge can be maintained in the vacuum arc evaporation source without the gas introduction.

The third vacuum arc evaporation apparatus, further may comprise: a magnetic filter disposed close to the at least one bar-like anode such that the bar-like anode is located between the magnetic member and the evaporating face of the cathode. Or, in the third vacuum arc evaporation apparatus, it is preferable that the bar-like anode is made of magnetic material.

In the vacuum arc evaporation apparatus, an increased number of magnetic lines pass through the anodes or their vicinity, so that electrons are easy to reach the anodes. Accordingly, the arc discharge in a strong magnetic field is easy.

The above-mentionedobject can be also achieved by a fourth vacuum arc evaporation apparatus according to the present invention, comprising: a vacuum arc evaporation source including a cathode and an anode located in front of an evaporating face of the cathode, the vacuum arc evaporation source generating stream of plasma containing cathode materials by evaporating cathode materials from the cathode under a vacuum arc discharge between the cathode and the anode; and a magnetic filter for curving and transporting the plasma stream generated by the vacuum arc evaporation source by a magnetic field to remove coarse particles from the plasma stream, and outputting the plasma stream in which coarse particles have been removed, wherein the anode of the vacuum arc evaporation source includes at least one bar-like anode which is disposed such that one end face of the bar-like anode is directed to the front of the evaporating face of the cathode.

In the fourth vacuum arc evaporation apparatus, even in a case where an intensity of magnetic field developed by the magnetic filter is increased and magnetic lines of force developed by the magnetic coil passes through the evaporating face in the direction substantially perpendicular to the evaporating face, the electrons captured by the magnetic lines are easy to reach the anode and hence the arc discharge can be maintained since the anode is located along the magnetic lines. Accordingly, even in such a case of increasing the transport efficiency of the plasma stream by increasing the intensity of magnetic field generated by the magnetic filter, the arc discharge can be maintained in the vacuum arc evaporation source without introducing the gas into the transporting duct, as in other apparatuses.

Where the anode is thus disposed, electrons collide with the anode, whereby the arc discharge is well maintained since the Raman radius of the electron is different from that of the ion in a magnetic field (the former is smaller than the latter) . A probability that the ions in the plasma are transported downstream while not colliding with the anode is high. Accordingly, the efficiency of transporting plasma stream is improved when comparing with the third vacuum arc evaporation apparatus.

The fourth vacuum arc evaporation apparatus, further may comprise: a magnetic filter disposed close to the at least one bar-like anode such that the bar-like anode is located between the magnetic member and the evaporating face of the cathode. Or, in the fourth vacuum arc evaporation apparatus, the anode is made of magnetic material.

In the vacuum arc evaporation apparatus, an increased number of magnetic lines pass through the anodes or their vicinity, so that electrons are easy to reach the anodes. Accordingly, the arc discharge in a strong magnetic field is easy.

In the first to fourth vacuum arc evaporation apparatus, a potential at the magnetic member may be equal to that at the anode.

In the vacuum arc evaporation apparatus, there is no need of taking no electrical insulation measure for them. In this respect, the insulation design is easy.

Preferably, in the vacuum arc evaporation apparatus, the magnetic member is mounted on the anode in the vacuum arc evaporation source.

In the vacuum arc evaporation apparatus, the anode serves also as a support of the magnetic member. Accordingly, the support of the magnetic member is easy.

In the first to fourth vacuum arc evaporation apparatus, a potential of the magnetic member also may be a floating potential.

In the vacuum arc evaporation apparatus, charged particles are hard to approach to the magnetic member. Accordingly, less heat generated by the collision of the charged particles on the magnetic member is generated, and hence the cooling of the magnetic member is easy.

The first to fourth vacuum arc evaporation apparatus, further may comprise: a cooling mechanism for cooling the magnetic member by a refrigerant which is disposed in as sociation with the magnetic member, or a cooling mechanism for cooling the anode by a refrigerant which is disposed in association with the anode.

In the vacuum arc evaporation apparatus, there is no chance that the magnetic member is excessively heated and as a result, it is deformed, damaged or the like, or there is no chance that the anode is excessively heated and as a result, it is deformed, damaged or the like.

In the first to fourth vacuum arc evaporation apparatus, the cathode may be made of carbon or a material mainly containing carbon.

In a case where the cathode is made of carbon or a material mainly containing carbon, the maintaining of the arc discharge is very difficult for the prior art technique. On the other hand, the vacuum arc evaporation apparatus according to the present invention can maintain the arc discharge in the strong magnetic field even if the cathode is made of a carbon material and no gas introduction is made. This feature will produce effects that are more advantageous.

### BRIEF DESCRIPTION OF THE DRAWINGS

Fig. 1 is a cross sectional view showing a film-forming apparatus with a vacuum arc evaporation apparatus incorporated thereinto;
Fig. 2 is an enlarged, front view showing a portion including a cathode, an anode and a magnetic member;
Fig. 3 is a diagram showing a distribution of magnetic lines of force in a region including the cathode and the anode and its vicinity in the vacuum arc evaporation apparatus;
Fig. 4 is a cross sectional view showing a key portion of another vacuum arc evaporation apparatus;
Fig. 5 is a diagram showing another arrangement of the magnetic member;
Fig. 6 is a cross sectional view showing a key portion of yet another vacuum arc evaporation apparatus;
Fig. 7 is an enlarged, front view showing a portion including cathodes, an anode and a magnetic member in a vacuum arc evaporation apparatus which uses two cathodes;
Fig. 8A is a front view showing another arrangement of anodes and a magnetic member in the vacuum arc evaporation apparatus;
Fig. 8B is a side view showing the same as Fig. 8A;
Fig. 9A is a front view showing yet another arrangement of anodes and a magnetic member in the vacuum arc evaporation apparatus;
Fig. 9B is a side view showing the same as Fig. 9A;
Fig. 10A is a front view showing an additional arrangement of anodes and a magnetic member in the vacuum arc evaporation apparatus;
Fig. 10B is a side view showing the same as Fig. 10A;
Fig. 11 is a cross sectional view showing a film-forming apparatus having a prior art vacuum arc evaporation apparatus;
Fig. 12 is a diagram showing a distribution of magnetic lines of force in a region including the cathode and the anode and its vicinity in the Fig. 11 vacuum arc evaporation apparatus; and
Fig. 13 is a cross sectional view showing a film-forming apparatus having a prior art vacuum arc evaporation apparatus not using a magnetic filter.

### DETAILED DESCRIPTION OF THE PREFERRED EMBODIMENT

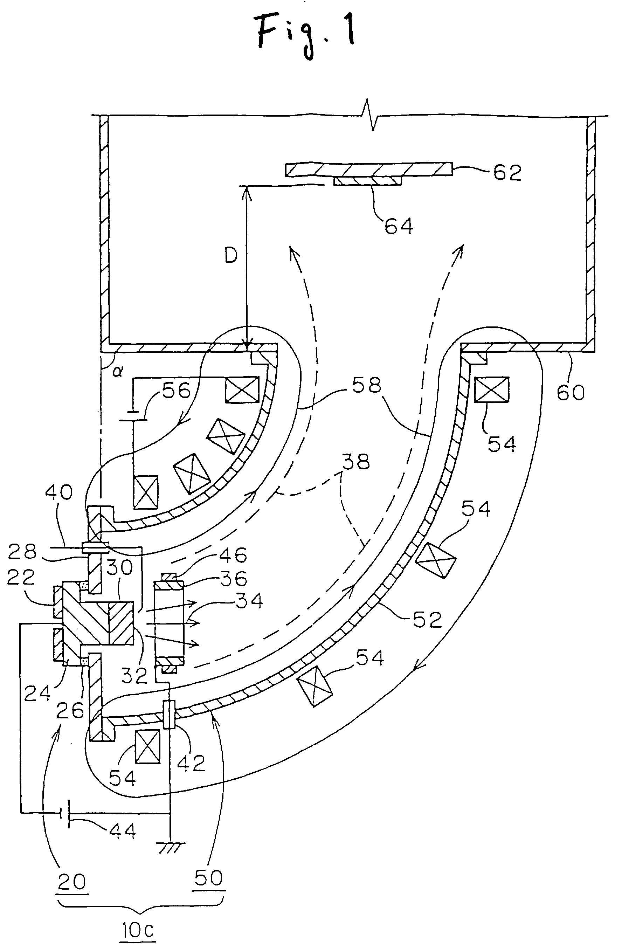

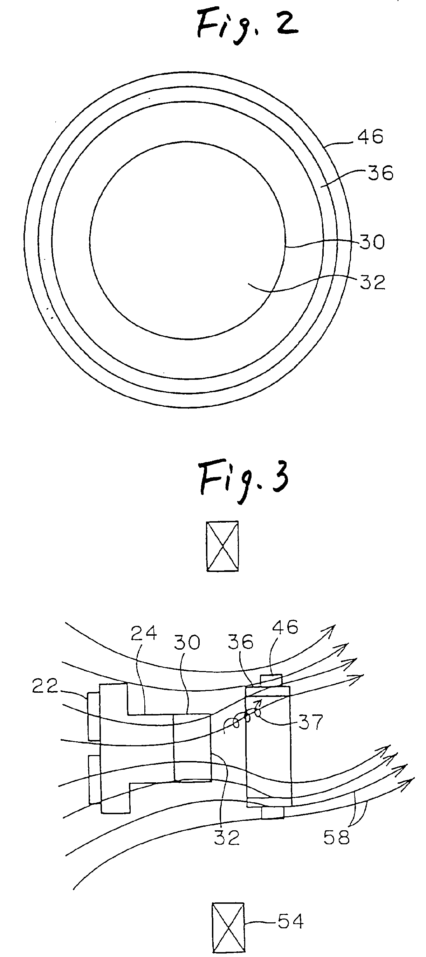

Fig. 1 is a cross sectional view showing a film-forming apparatus having a vacuum arc evaporation device incorporated thereinto, which is constructed according to the invention. Fig. 2 is an enlarged, front view showing a cathode, an anode and a magnetic member in the film-forming apparatus of Fig. 1. In the figures, like reference numerals will be used for designating like or equivalent portions in the prior art film-forming apparatus shown in Fig. 11, and description will be given placing emphasis on differences from the prior art film-forming apparatus.

In the vacuum arc evaporation apparatus designated by reference numeral 10c, a cylindrical or annular magnetic member 46 is mounted on an outer peripheral part of a cylindrical or annular anode 36 as stated above in a vacuum arc evaporation source 20. The magnetic member 46 is set at a potential equal to the anode 36 (it is grounded in the embodiment).

As stated above, the anode 36 is located in front of an evaporating face 32 of the cathode 30. Accordingly, the magnetic member 46 mounted on the outer peripheral part thereof is also located in front of the evaporating face 32. With the mounting of the magnetic member 46 on the outer peripheral part of the anode 36, the anode 36 is located between the magnetic member 46 and the evaporating face 32 of the cathode 30.

The magnetic member 46 may be made of a ferromagnetic material, such as iron, nickel, cobalt, an alloy containing them, or ferrite. Specific examples of those materials that may be used for the magnetic member 46 are structural carbon steel (e.g., SS400 of JIS), ferrite stainless steel, martensitic stainless steel (both of them are magnetic stainless steel), NiFe, and CoPt.

The magnetic member 46 thus disposed configures a distribution of the magnetic lines 58 of force developed by the magnetic filter 50 (exactly a magnetic coil 54 thereof) in the region ranging from the cathode 30 to the anode 36 in the vacuum arc evaporation source 20 so as to be suitable for the maintaining of arc discharge between the cathode 30 and the anode 36.

Specifically, with the mounting of the magnetic member 46 on the outer peripheral part of the anode 36, the magnetic lines developed by the magnetic coil 54 of the magnetic filter 50 are attracted in part to the magnetic member 46, as shown in Fig. 3. Accordingly, the magnetic lines 58 that are directed to the anode 36 of the vacuum arc evaporation source 20 or its vicinity, more exactly the magnetic lines 58 passing through a region ranging from the cathode 30 to the anode 36 and its vicinity in the vacuum arc evaporation source 20, are increased in number. This phenomenon occurs also when the field strength of the magnetic filter 50 is increased.

The magnetic lines 58 thus configured in distribution effectively contributes to the maintaining of the arc discharge in the vacuum arc evaporation source 20. As the result of the increase of the flux density, of electrons that are emitted from the cathode 30 by the arc discharge, those electrons that are captured by the magnetic lines 58 of force passing through the anode 36 and its vicinity, and reach the anode 36, are increased in number. An electron 37 reaching the anode 36 is illustrated in model form in Fig. 3. With this, the initial arc discharge and the maintaining of the subsequent arc discharge are easy in the vacuum arc evaporation source 20, whereby the arc discharge is stabilized. The same thing is true for the case where an intensity of the magnetic field by the magnetic filter 50 is increased.

Also in a case where the transporting efficiency of a stream of plasma 38 is improved by increasing an intensity of magnetic field developed by the magnetic filter 50, the arc discharge can be stabilized and maintained in the vacuum arc evaporation source 20 without introducing discharge maintaining gas, e.g., inert gas, transporting duct. Accordingly, the transport efficiency improvement of the plasma stream 38 in the magnetic filter 50 and the arc discharge maintaining in the vacuum arc evaporation source 20 can both be secured without the gas introduction.

Thus, the film-forming apparatus having the thus constructed vacuum arc evaporation apparatus can form a film on a substrate 64 at high rate in a manner that the plasma stream 38 is transported at high transport efficiency, while removing coarse particles, and further can eliminate the adverse effect on the formed film by the gas introduction. Those advantageous effects may be achieved by very simple construction, viz., provision of the magnetic member 46. This fact also suppresses the apparatus size increase.

In a case where the cathode 30 is made of carbon or a material mainly containing carbon, the maintaining of the arc discharge is very difficult for the prior art technique, as described above. On the other hand, the invention can maintain the arc discharge in the strong magnetic field even if the cathode 30 is made of a carbon material and no gas introduction is made. This feature will produce effects that are more advantageous.

The potential of the magnetic member 46 may be equal to that of the anode 36, a floating potential, or a medium potential between the potentials of the anode 36 and the cathode 30. The reason for this is that what is important for the magnetic member 46 is not its potential, but its function to attract the magnetic lines 58 and direct them to the anode 36. The same thing is true for other embodiments.

A simple way to put the magnetic member 46 and the anode 36 at the equal potential is to mount the magnetic member 46 on the anode 36 as in the Fig. 1 case. Another way is to place those at different positions and to electrically connect them to each other. Where the magnetic member 46 and the anode 36 are set at the equal potential, there is no need of taking no electrical insulation measure for them. In this respect, the insulation design is easy.

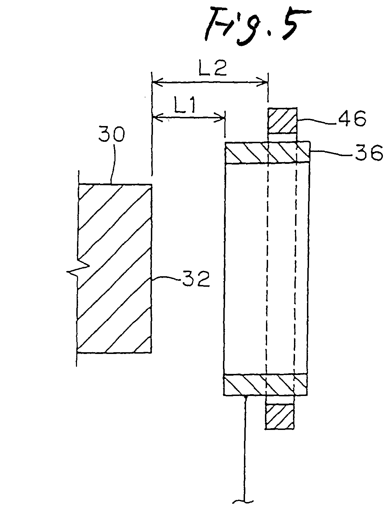

Fig. 5 shows an example structure where the potential of the magnetic member 46 is set at the floating potential. In the structure, as shown, the magnetic member 46 is disposed close to and around the outer peripheral part of the anode 36. In this case, an insulating material may be interposed between the magnetic member 46 and the anode 36. When the magnetic member 46 is set at a floating potential, charged particles, e.g., ions, are hard to approach to the magnetic member 46. Accordingly, less heat generated by the collision of the charged particles on the magnetic member 46 is generated, and hence the cooling of the magnetic member 46 is easy.

The magnetic member 46, as described above, is preferably located outside the anode 36 (as viewed in the radial direction of the anode 36) or downward of the anode 36 (as viewed in the traveling direction of cathode materials 34). In other words, the magnetic member 46 is preferably disposed so that the anode 36 is located between it and the evaporating face 32 of the cathode 30. If so done, the magnetic member 46 is not interposed between the evaporating face 32 of the cathode 30 and the anode 36. Accordingly, electrons 37 (Fig. 3) that are emitted from the cathode 30 and captured by the magnetic lines 58 of force are easy to reach the anode 36. In a case where the potential at the magnetic member 46 is the floating potential or the medium potential, it is especially preferable to dispose the magnetic member 46 as mentioned above. In the case where the magnetic member 4 6 and the anode 36 are at the equal potential, the magnetic member 46 may be considered as a part of the anode when viewed from an electrical standpoint. Accordingly, it is not essential to dispose the magnetic member 46 as mentioned above.

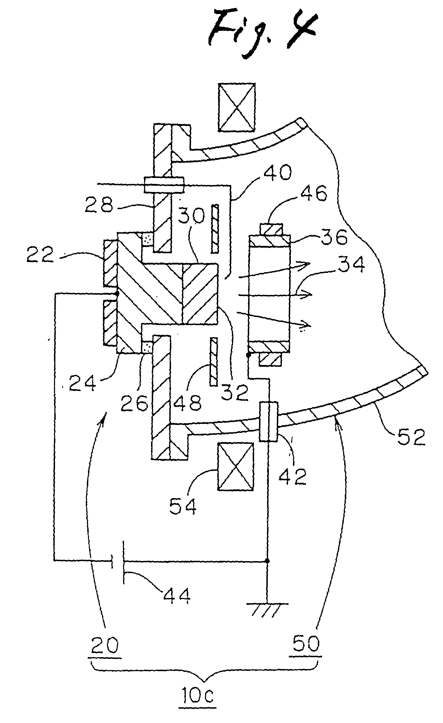

By convention, an annular arc spot confining plate 48 made of magnetic material sometimes is provided on the outer periphery of the cathode 30 as in the instance shown in Fig. 4. The arc spot confining plate 48 is flush with the evaporating face 32 of the cathode 30, while surrounding the evaporating face 32. Since the arc spot confining plate 48 is made of magnetic material, it shapes a magnetic flux derived from a magnet 22 and confines a movement of an arc spot within the evaporating face 32 of the cathode 30.

The arc spot confining plate 48 with such a function and the magnetic member 46 may be combined in use. The same thing is true for other embodiments to be given later. The arc spot confining plate 48 and the magnetic member 46 are quite different from each other in their locations and functions, as described above. Accordingly, in a case where the arc spot confining plate 48 is provided and the magnetic member 46 is not provided, it is impossible for the arc spot confining plate 48 to produce the operation and advantageous effect as those of the magnetic member 46. The position at which the arc spot confining plate 48 is located is not the position at which the magnetic member 46 is located, viz., in front of the evaporating face 32 of the cathode 30 and near the anode 36. Accordingly, the arc spot confining plate 48 cannot have such a function that the number of magnetic lines of force going to the anode 36 is increased to maintain the arc discharge in a strong magnetic field.

If a distance L1 between the evaporating face 32 of the cathode 30 and the anode 36, and a distance L2 between the evaporating face 32 and the magnetic member 46 (see Fig. 5) is too small, a spread of the arc discharge is small. If those distances are too large, it is difficult to maintain the arc discharge. To avoid this, those distances are selected to preferably be within 30mm to 120mm, more preferably 50mm to 80mm.

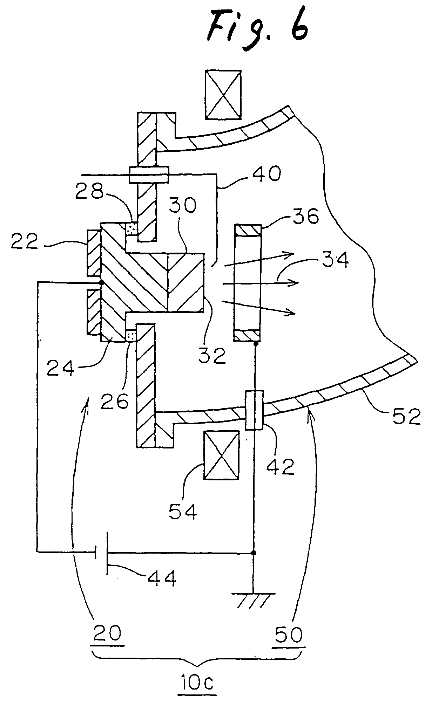

Another or second embodiment of the present invention will be described. In the first embodiment described above, the magnetic member 46 is provided separately from the anode 36. In the second embodiment, however, as shown in Fig. 6, the anode 36 in the vacuum arc evaporation source 20 is made of magnetic material (ferromagnetic material as already described, and the same thing is correspondingly applied to the other embodiments), and functions also as the magnetic member.

By so constructed, the anode 36 per se attracts the magnetic lines 58 of force generated by the magnetic coil 54. Accordingly, the number of magnetic lines of force going to the anode 36 is increased, so that the arc discharge may be maintained in a strong magnetic field. Also, in the case where the efficiency of transporting the plasma stream 38 is increased by increasing the field strength of the magnetic filter 50, the arc discharge can be maintained without introducing the gas into a transporting duct 52.

Where the magnetic member 46 is provided separately from the anode 36, materials suitable for those members may be selected independently; a material suitable for the magnetic member 46 is selected and a material suitable for the anode 36 is selected. In a specific example, copper being high in electrical and thermal conductivity is used for the anode 36, and structural carbon steel being cheap and high in magnetic permeability is used for the magnetic member 46. Where the anode 36 is made of a ferromagnetic material to additionally have the function of the magnetic member, the number of required component parts is reduced and the construction is simplified. The same thing is true for the remaining embodiments.

The magnetic member 46 is heated by charged particles penetrating thereinto, radiant heat radiated from the cathode surface and the like to have an increased temperature. To cope with this, it is preferable to use a cooling mechanism for cooling the magnetic member by a refrigerant, e.g., a coolant. By so doing, there is no chance that the magnetic member 46 is excessively heated and as a result, it is deformed, damaged or the like. A specific means to cope with this is to lay a cooling pipe through which a coolant flows on and along the peripheral surface of the magnetic member 46. The same thing is correspondingly applied to the remaining embodiments.

In a case where the anode 36 is made of a magnetic material to additionally have the function of the magnetic member, as in the Fig. 6 case, it is preferable to apply the cooling mechanism as last stated to the anode 36. By so doing, there is no chance that the anode 36 is excessively heated to be deformed, damaged or the like. The same thing is true for the other embodiments.

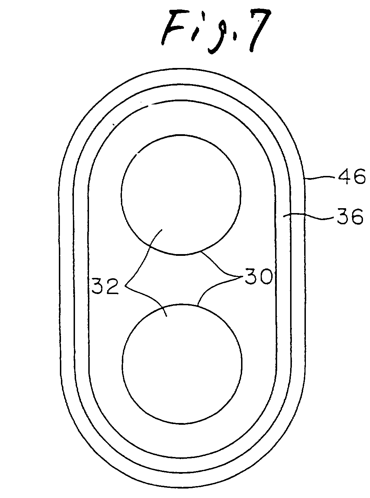

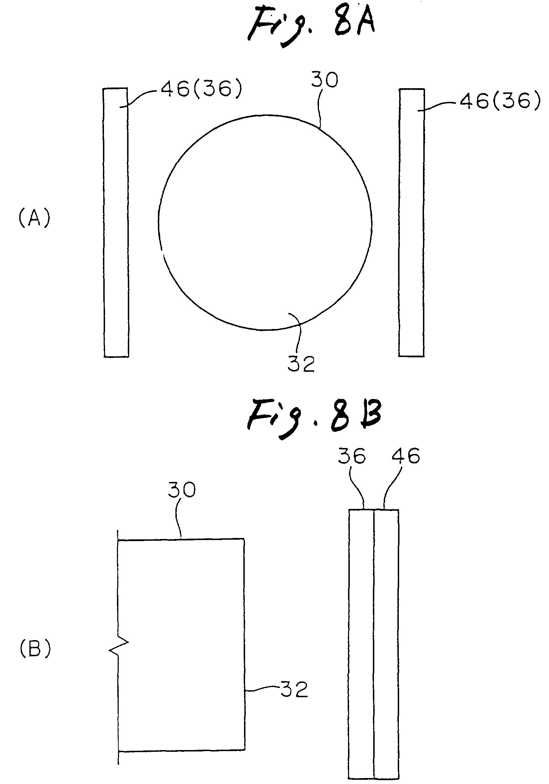

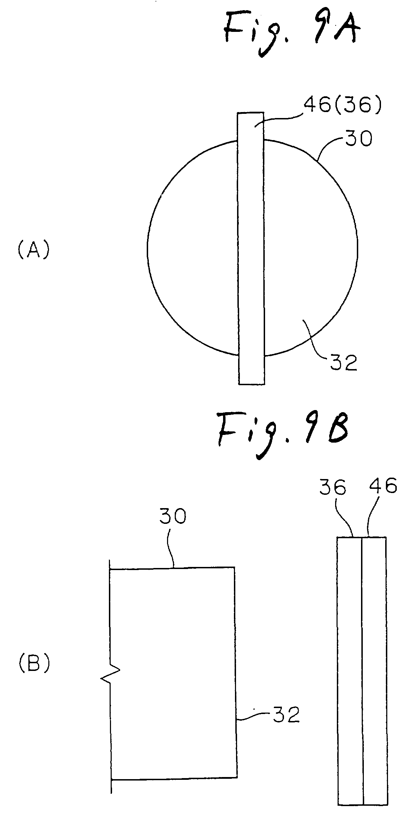

The vacuum arc evaporation source 20 may be provided with a plurality of cathodes 30. In this case, an anode 36 and a magnetic member 46, as constructed above, may be used commonly for those cathodes 30. Fig. 7 illustrates a case where two cathodes 30 are used. The combination o the anode 36 and the magnetic member 46 may be oval in flat surface shape as illustrated or elliptic. The same thing is true for the case where the anode 36 is made of a magnetic material to additionally have the function of the magnetic member.

In either embodiment, the anode 36 of the vacuum arc evaporation source 20 is configured such that when positioned in place, it surrounds the front part of the cathode 30. The magnetic member 46 is disposed on or near the outer peripheral part of the anode 36 in a state that it is located in front of the cathode 30 while surrounding the front part of the same. In an alternative, the anode 36 is made of a magnetic material, and serves also as the magnetic member . The anode 36 or magnetic member 46 so shaped as to surround the front part of the cathode 30 may be a tubular member whose cross section is circular, oval, elliptic, or square, or an annular member (involving a plate with a hole formed therein).

The reason why the anode 36 is so shaped is that the anode 36 hardly intercepts (hinders) the cathode materials 34 evaporating from the evaporating face 32 of the cathode 30 and the plasma stream 38 derived therefrom. Where the anode 36 is thus shaped, if the intensity of the magnetic field of the magnetic filter 50 is increased, the magnetic lines 58 of force generated by the magnetic coil 54 pass through the space inside the anode 36, as shown in Fig. 12. With this, electrons 37 emitted from the cathode 30 do not hit the anode 36 but easily pass through the same. Accordingly, the advantageous effects resulting from the provision of the magnetic member 46 or of the case where the anode 36 is made of the magnetic material and serves also as the magnetic member are more manifestly produced.

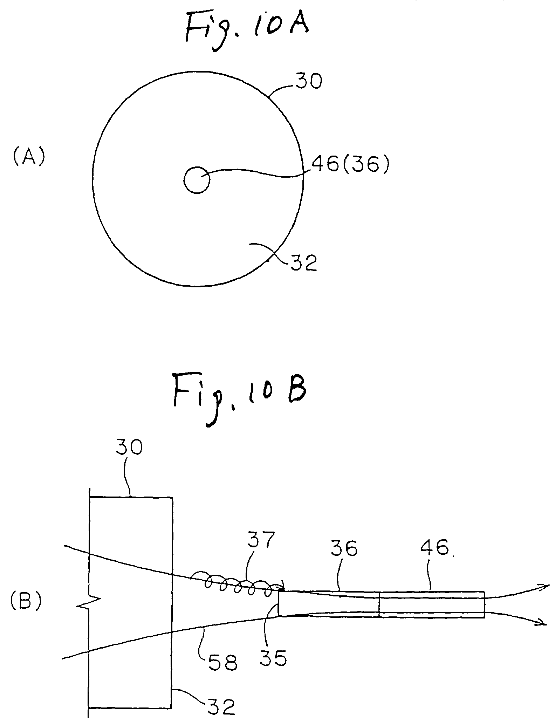

Another structure of the anode 36 and its arrangement in the vacuum arc evaporation source 20 is illustrated in Figs. 8A and 8B. As shown, a plurality of bars (two bars in the illustrated instance) are disposed along (e.g., parallel to) the evaporating face 32, while being located outside the evaporating face 32 of the cathode 30. Also, in this instance, as in the instance where the anode 36 surrounds the front part of the cathode 30, if the field strength developed by the magnetic filter 50 is increased, electrons emitted from the cathode 30 are easy to pass through the anode 36 while not hitting the anode 36.

Also, in this case, it is sufficient to provide the magnetic members 46 at positions which are located in front of the evaporating face 32 of the cathode 30 and near the anodes 36. Specifically, as in the Figs. 8A and 8B instance, the magnetic members 46 are disposed such that the anodes 36 are located between the magnetic members 46 and the evaporating face 32 of the cathode 30 and close to the anodes 36. In an alternative, the anodes 36 may be made of a magnetic (ferromagnetic) material so as to additionally have the function of the magnetic member, instead of provision of the magnetic members 46.

Also in this case, the magnetic members 46 or the anodes 36 made of a magnetic material draws, by itself, the magnetic lines 58 of force developed by the magnetic coil 54 of themagnetic filter 50 to the anodes 36 or their vicinity. As a result, the number of magnetic lines 58 going to the anodes 36 is increased, and this enables the arc discharge in the strong magnetic field to be maintained. Accordingly, also when the intensity of the magnetic field generated by the magnetic filter 50 is increased to increase the transport efficiency of the plasma stream 38 as in the above instance, the arc discharge may be maintained in the vacuum arc evaporation source 20 without introducing the gas into the transporting duct 52.

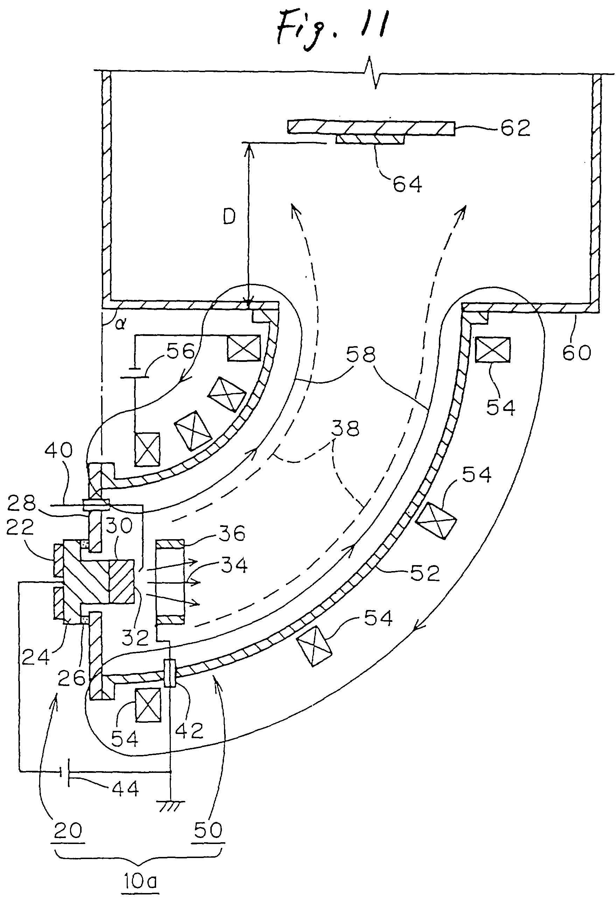

Yet another structure of the anode 36 and its arrangement is illustrated in Fig. 9A and 9B. In this structure, as shown, one or more number of bar-like anodes 36 (one bar-like anode in this instance) may be disposed in front of the evaporating face 32 of the cathode 30 while being extended along (e.g., parallel to) the evaporating face 32. In this case, it is not essential to use the magnetic member 46 and to make the anode 36 of the magnetic material.

Also in a case where an intensity of magnetic field developed by the magnetic filter 50 is increased and magnetic lines 58 of force developed by the magnetic coil 54 passes through the evaporating face 32 in the direction perpendicular to the evaporating face, as shown in Fig. 12, the electrons 37 captured by the magnetic lines 58 are easy to reach the anode 36 and hence the arc discharge can be maintained since the anode 36 is located crossing the magnetic lines 58. Accordingly, even in such a case of increasing the transport efficiency of the plasma stream 38 by increasing the intensity of magnetic field generated by the magnetic filter 50, the arc discharge can be maintained in the vacuum arc evaporation source 20 without introducing the gas into the transporting duct 52.

Also, in the Figs. 9A and 9B case, the magnetic member 46 may be provided or the anode 36 may be made of a magnetic (ferromagnetic) material, as in the Figs. 8A and 8B case. In the case using the magnetic member 46, it is located in front of the evaporating face 32 of the cathode 30 and close to each anode 36. Specifically, it is sufficient to dispose the magnetic member 46 such that the anode 36 is located between the magnetic member 46 and the evaporating face 32 of the cathode 30, as in the Figs. 9A and 9B case.

If so arranged, the increased number of magnetic lines 58 of force pass through and near the anode 36, and electrons 37 are easy to reach the anode 36. Accordingly, it is easy to maintain the arc discharge in the strong magnetic field.

A further anode structure and its arrangement are shown in Figs. 10A and 10B. At least one bar-like anode 36 (one anode in the illustrated instance) is arranged such that one end face 35 of the bar-like anode is directed to the front of the evaporating face 32 of the cathode 30. Also, in this case, it is not essential that the magnetic member 46 is provided or the anode 36 is made of a magnetic material. The length of the anode 36 may be increased more than the Figs. 10A and 10B anode, whenever occasion calls.

Also in a case where an intensity of magnetic field developed by the magnetic filter 50 is increased and magnetic lines 58 of force developed by the magnetic coil 54 passes through the evaporating face 32 in the direction substantially perpendicular to the evaporating face 32, as shown in Fig. 12, the electrons 37 captured by the magnetic lines 58 are easy to reach the anode 36 and hence the arc discharge can be maintained since as shown in Fig. 10B, the anode 36 is located along the magnetic lines 58. Therefore, even in such a case of increasing the transport efficiency of the plasma stream 38 by increasing the intensity of magnetic field generated by the magnetic filter 50, the arc discharge can be maintained in the vacuum arc evaporation source 20 without introducing the gas into the transporting duct 52.

Where the anode 36 is thus arranged, the Raman radius of the electron 37 emitted from the evaporating face 32 is small in the magnetic field. Accordingly, the electrons 37 collide with the anode 36, so that the arc discharge is well maintained. On the other hand, ions in the plasma stream 38 are heavy, and their Raman radius is much larger than that of the electrons 37 (the radius is 1cm or larger although it depends on the intensity of the magnetic field). Accordingly, the ions do not hit the anode 36, and hence, a probability that the ions are transported downstream is high. For this reason, the transport efficiency of the plasma stream 38 is higher than in the Figs. 9A and 9B case.

In those cases of Figs. 10A and 10B, and Figs. 9A and 9B, to reduce a rate at which the anode 36 and the magnetic member 46 hinder the transportation of the plasma stream 38, it is suggestible that the anode 36 and the magnetic member 46 are formed to be as thin as possible within a range of their thickness values within which a stable arc discharge is secured.

Also, in the Figs. 10A and 10B case, the magnetic member 46 may be provided or the anode 36 may be made of a magnetic (ferromagnetic) material as in the Figs. 9A and 9B case. In the case using the magnetic member 46, it is located in front of the evaporating face 32 of the cathode 30 and close to each anode 36. Specifically, it is sufficient to dispose the magnetic member 46 such that the anode 36 is located between the magnetic member and the evaporating face 32 of the cathode 30, as in the Figs. 10A and 10B case.

If so arranged, the increased number of magnetic lines 58 of force pass through and near the anode 36, and electrons 37 are easy to reach the anode 36. Accordingly, it is easy to maintain the arc discharge in a strong magnetic field.

Also, in the Figs. 8A through 10B cases, the matters on the setting of the potential of the magnetic member 46, whether or not the magnetic member 46 is coupled to the anode 36, and whether or not the cooling mechanism is coupled to the magnetic member 46 and the anode 36 may be considered as in the previous embodiments. Further, the advantageous effects are remarkably manifested when the cathode 30 is made of carbon or a material mainly containing it, as in the previous embodiments.

For the magnetic filter 50, a magnetic field may be formed which extends and curves along the transporting duct 52 by using a plurality of permanent magnets in place of the magnetic coil 54. In this case, the DC power source 56 is not required.

The transporting duct 52 of the magnetic filter 50 may electrically be grounded or a bias voltage may be applied to the transporting duct 52.

### [EXAMPLES]

### <Example 1>

A film-forming test was conducted by using a film-forming apparatus having a vacuum arc evaporation apparatus 10c in which a magnetic member 46 is firmly mounted on the outer peripheral part of the anode 36 as shown in Fig. 1. The test conditions were as given hereunder, and the test results are shown in Table 1.

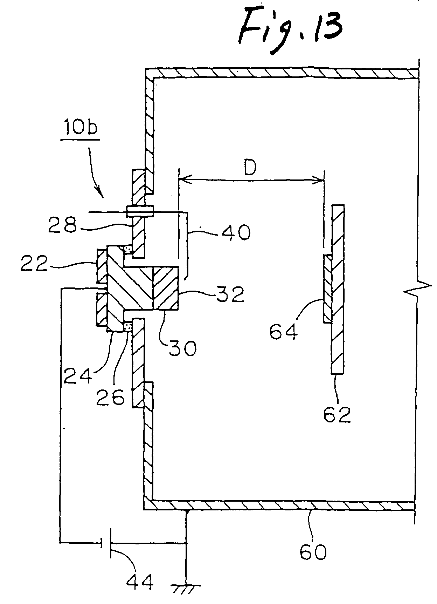

SS400 of JIS is a kind of structural carbon steel. Currents flowing through the four coils of the magnetic coil 54 were equal to one another. A film-forming rate in the table was ratio with that in a case using a vacuum arc evaporation apparatus 10b not using the magnetic filter as shown in Fig. 13. A distance D used for comparison was a distance ranging from the evaporating face 32 of the cathode 30 to the substrate 64 as shown in Fig. 13, when the magnetic filter is not used. When the magnetic filter is used, it was a distance ranging from the exit of the magnetic filter 50 to the substrate 64 as shown in Fig. 1 and other figures. The distance D was 350mm in both cases, and in other examples and comparison.
Cathode 30 : carbon material (cylindrical, 60mm in diameter X 30mm long)
Arc current : 80A
Current of magnetic coil 54 : shown in Table
Degree of vacuum in the film-forming chamber : 1 x 10⁻³Pa
Anode 36 : copper material (cylindrical, 80mm in diameter x 50mm long x 2mm thick), water-cooled type
Magnetic member 46: SS400 of JIS (cylindrical, 84mm in diameter x 5mm long x 2mm thick), anode potential
Gas introduction to the transporting duct 52: not introduced.

**[Table 1]**

| Magnetic coil current(A) | Arc discharge Maintaining | Film-forming rate |
|---|---|---|
| 10 | possible | 1/10 |
| 20 | ditto | 1/5 |
| 50 | ditto | 1/4 |
| 100 | ditto | 1/3 |
| 150 | ditto | 1/2 |

As seen from Table 1, even when an intensity of magnetic field generated by the magnetic filter 50 is increased by increasing the current of the magnetic coil 54 from 10A to 150A, the arc discharge could be maintained for every current value of the magnetic coil. When the coil current was 150A, a film-forming rate was very fast, 1/2 as large as that in the case not using the magnetic filter 50. This is due to the fact that the transport efficiency of the plasma stream 38 in the magnetic filter 50 is increased by the strong magnetic field.

### <Comparison>

For comparison, a film-forming test was conducted by using a film-forming apparatus having a vacuum arc evaporation apparatus 10a shown in Fig. 11. The vacuum arc evaporation apparatus 10a did not use the magnetic member, and test conditions except this are the same as these in the example 1. The test results are shown in Table 2.

**[Table 2]**

| Magnetic coil current(A) | Arc discharge Maintaining | Film-forming rate |
|---|---|---|
| 10 | possible | 1/8 |
| 20 | difficult | - |
| 50 | ditto | - |
| 100 | ditto | - |
| 150 | ditto | - |

As seen from Table 2, the arc discharge could not be maintained in the vacuum arc evaporation source 20 when the current of the magnetic coil 54 exceeds 10A. A maximum of the film-forming rate in the comparison was 1/8. This value is just 1/4 (25%) as large as the maximum filing forming rate (1/2) in the example 1.

### <Example 2>

A film-forming test was conducted by using a film-forming apparatus including a vacuum arc evaporation apparatus 10c in which a magnetic member 46 is disposed close to and around the outer peripheral part of the anode 36 as shown in Fig. 5. In the example 2, the magnetic member 46 was made of SS400 of JIS, and cylindrical in shape, and its size was 85 in diameter x 5mm long x 2mm thick. It was electrically insulated from the anode 36, and hence, its potential was floating potential. The remaining conditions were the same as those in the example 1.

The test results are shown in Table 3.

**[Table 3]**

| Magnetic coil current(A) | Arc discharge Maintaining | Film-forming rate |
|---|---|---|
| 10 | possible | 1-10 |
| 20 | ditto | 1/5 |
| 50 | ditto | 1/4 |
| 100 | ditto | 1/3 |
| 150 | ditto | 1/2 |

As seen from the table, the test results were exactly the same as in Table 1.

### <Example 3>

A film-forming test was conducted by using a film-forming apparatus including a vacuum arc evaporation apparatus 10c in which the anode 36 is made of magnetic material and serves also as the magnetic member as shown in Fig. 6. In the example 3, the anode 36 was made of SS400 of JIS, and its shape was annular and its size was 85mm in diameter x 5mm long x 2mm thick. The anode 36 was of the water-cooled type. The other conditions than those were the same as those in the example 1. The test results are show in Table 4.

**[Table 4]**

| Magnetic coil current(A) | Arc discharge Maintaining | Film-forming rate |
|---|---|---|
| 10 | possible | 1/12 |
| 20 | ditto | 1/7 |
| 50 | ditto | 1/5 |
| 100 | ditto | 1/4 |
| 150 | ditto | 1/3 |

As seen from Table 4, the test results were substantially the same as in the example 1. Specifically, even when an intensity of magnetic field generated by the magnetic filter 50 is increased by increasing the current of the magnetic coil 54 from 10A to 150A, the arc discharge could be maintained for every current value of the magnetic coil. When the coil current was 150A, a film-forming rate was very fast, 1/3 as large as that in the case not using the magnetic filter 50.

## Claims

1. A vacuum arc evaporation apparatus comprising:
a vacuum arc evaporation source including a cathode and an anode located in front of an evaporating face of said cathode, said vacuum arc evaporation source generating stream of plasma containing cathode materials by evaporating cathode materials from said cathode under a vacuum arc discharge between said cathode and said anode;
a magnetic filter for curving and transporting the plasma stream generated by said vacuum arc evaporation source by a magnetic field to remove coarse particles from the plasma stream, and outputting the plasma stream in which coarse particles have been removed; and
a magnetic member disposed in front of the evaporating face of said cathode and close to said anode in said vacuum arc evaporation source.

2. The vacuum arc evaporation apparatus according to claim 1, wherein said anode is located between said magnetic member and the evaporating face of said cathode.

3. The vacuum arc evaporation apparatus according to claim 1, wherein said anode of said vacuum arc evaporation source is configured such that when positioned in place, said anode surrounds the front part of said cathode, and said magnetic member is disposed on or near an outer peripheral part of said anode in a state that said magnetic member is located in front of said cathode while surrounding the front part of said cathode.

4. The vacuum arc evaporation apparatus according to claim 2, wherein said anode of said vacuum arc evaporation source includes a plurality of bar-like members, which are disposed along the evaporating face of said cathode while being located outside said evaporating face of said cathode.

5. A vacuum arc evaporation apparatus comprising:
a vacuum arc evaporation source including a cathode and an anode located in front of an evaporating face of said cathode, said vacuum arc evaporation source generating stream of plasma containing cathode materials by evaporating cathode materials from said cathode under a vacuum arc discharge between said cathode and said anode; and
a magnetic filter for curving and transporting the plasma stream generated by said vacuum arc evaporation source by a magnetic field to remove coarse particles from the plasma stream, and outputting the plasma stream in which coarse particles have been removed,
wherein said anode of said vacuum arc evaporation source is made of a magnetic material.

6. The vacuum arc evaporation apparatus according to claim 5, wherein said anode of said vacuum arc evaporation source is configured such that when positioned in place, said anode surrounds the front part of said cathode.

7. The vacuum arc evaporation apparatus according to claim 5, wherein said anode of said vacuum arc evaporation source includes a plurality of bar-like members, which are disposed along the evaporating face of said cathode while being located outside said evaporating face of said cathode.

8. A vacuum arc evaporation apparatus comprising:
a vacuum arc evaporation source including a cathode and an anode located in front of an evaporating face of said cathode, said vacuum arc evaporation source generating stream of plasma containing cathode materials by evaporating cathode materials from said cathode under a vacuum arc discharge between said cathode and said anode; and
a magnetic filter for curving and transporting the plasma stream generated by said vacuum arc evaporation source by a magnetic field to remove coarse particles from the plasma stream, and outputting the plasma stream in which coarse particles have been removed,
wherein said anode of said vacuum arc evaporation source includes at least one bar-like anode which is disposed in front of the evaporating face of said cathode while being extended along said evaporating face.

9. The vacuum arc evaporation apparatus according to claim 8, further comprising:
a magnetic filter disposed close to said at least one bar-like anode such that said bar-like anode is located between said magnetic member and said evaporating face of said cathode.

10. The vacuum arc evaporation apparatus according to claim 8, wherein said bar-like anode is made of magnetic material.

11. A vacuum arc evaporation apparatus comprising:
a vacuum arc evaporation source including a cathode and an anode located in front of an evaporating face of said cathode, said vacuum arc evaporation source generating stream of plasma containing cathode materials by evaporating cathode materials from said cathode under a vacuum arc discharge between said cathode and said anode; and
a magnetic filter for curving and transporting the plasma stream generated by said vacuum arc evaporation source by a magnetic field to remove coarse particles from the plasma stream, and outputting the plasma stream in which coarse particles have been removed,
wherein said anode of said vacuum arc evaporation source includes at least one bar-like anode which is disposed such that one end face of said bar-like anode is directed to the front of said evaporating face of said cathode.

12. The vacuum arc evaporation apparatus according to claim 11, further comprising:
a magnetic filter disposed close to said at least one bar-like anode such that said bar-like anode is located between said magnetic member and said evaporating face of said cathode.

13. The vacuum arc evaporation apparatus according to claim 11, wherein said anode is made of magnetic material.

14. The vacuum arc evaporation apparatus according to claim 1, wherein a potential at said magnetic member is equal to that at said anode.

15. The vacuum arc evaporation apparatus according to claim 1, wherein a potential of said magnetic member is a floating potential.

16. The vacuum arc evaporation apparatus according to claim 14, wherein said magnetic member is mounted on said anode in said vacuum arc evaporation source.

17. The vacuum arc evaporation apparatus according to claim 1, further comprising:
a cooling mechanism for cooling the magnetic member by a refrigerant which is disposed in association with said magnetic member.

18. The vacuum arc evaporation apparatus according to claim 3, further comprising:
a cooling mechanism for cooling the anode by a refrigerant which is disposed in association with said anode.

19. The vacuum arc evaporation apparatus according to claim 1, wherein said cathode is made of carbon or a material mainly containing carbon.

20. The vacuum arc evaporation apparatus according to claim 3, wherein said cathode is made of carbon or a material mainly containing carbon.

21. The vacuum arc evaporation apparatus according to claim 8, wherein said cathode is made of carbon or a material mainly containing carbon.

22. The vacuum arc evaporation apparatus according to claim 11, wherein said cathode is made of carbon or a material mainly containing carbon.
